# DEMANDE DE BREVET EUROPEEN

(11) **EP 0 681 364 A1**
(43) Date de publication de la demande: **08.11.1995**
(21) Numéro de dépôt: 95440020.6
(22) Date de dépôt: 28.04.1995
(51) Int. Cl.: H03D 3/26

(54) **Procédé et dispositif de réception d'au moins un signal d'entrée comprenant au moins une information codée**

(30) Priorité: 02.05.1994 FR 9405506
(71) Demandeur: ISA FRANCE S.A., F-25130 Villers-le-Lac (FR)
(72) Inventeur: Mossuz, Gabriel, F-74100 Annemasse (FR); Puthod, Pascal, F-74800 Arenthon (FR); Lardet-Vieudrin, Franck, F-25840 Blarians (FR); Brolly, Philippe, F-95150 Taverny (FR); Marianneau, Gilles, F-25000 Besancon (FR); Byczek, Patrice, F-74100 Annemasse (FR); Groslambert, Jacques, F-25000 Besancon (FR)
(74) Mandataire: Nithardt, Roland

(57) **Abrégé**

Le dispositif (10) pour la mise en oeuvre du procédé de l'invention et destiné à démoduler des signaux modulés angulairement, c'est-à-dire en phase ou en fréquence, comporte une antenne (11) de réception de signaux radio contenant des informations codées, modulant angulairement ces signaux, et des moyens d'extraction (12) de ces informations. Ces moyens d'extraction (12) comportent un préamplificateur (13), un étage (14) qui génère deux signaux en opposition de phase, un discriminateur (17), un amplificateur à gain variable (25), un démodulateur d'amplitude (26), un comparateur adaptatif (27), un circuit (28) de commande automatique du gain et un convertisseur analogique/numérique (44). Le discriminateur (17) comporte un résonateur à quartz (18) dont la courbe de résonance d'origine définit une bande passante et une pente de flanc déterminées, la fréquence des signaux étant discriminée en utilisant au moins partiellement un flanc de la courbe de résonance dudit résonateur à quartz.

## Description

La présente invention concerne un procédé de réception d'au moins un signal radio d'entrée comprenant au moins une information codée modulant angulairement ce signal, et d'extraction de cette information, ce procédé comportant les étapes consistant à capter ledit signal radio d'entrée, à le filtrer, à discriminer sa fréquence et à en extraire ladite information.

Elle concerne également un dispositif de réception d'au moins un signal radio d'entrée comprenant au moins une information codée modulant angulairement ce signal, et d'extraction de cette information, ce dispositif comportant une antenne de réception dudit signal radio d'entrée et des moyens d'extraction de ladite information.

Il existe actuellement des émetteurs fournissant différents types d'informations telles que des informations phoniques, des informations horaires, des informations codées ou toutes autres informations numériques. Parmi les émetteurs de signaux horaires les plus connus, on peut citer l'émetteur DCF 77 de la "Deutsche Bundespost" situé en Allemagne et émettant une onde modulée en amplitude, et l'émetteur TDF, situé en France, et émettant une onde de fréquence moyenne égale à 162 kHz, modulée en amplitude pour les informations phoniques et en phase pour les informations horaires.

Ces émetteurs sont associés à des récepteurs permettant d'extraire et de restituer sous une forme utilisable, les informations contenues dans l'onde porteuse. Les informations phoniques de l'émetteur TDF sont restituées par un récepteur radiophonique conventionnel alors que les autres informations doivent être extraites au moyen d'un autre type de récepteur adapté au type d'informations transmises.

Un récepteur destiné à capter les signaux de l'émetteur DCF et à en extraire les informations est par exemple décrit dans la demande de brevet publiée sous le N° EP-A-0 201 061. Ce récepteur comporte un circuit d'antenne accordé, un préamplificateur à gain variable, un filtre et un.redresseur connectés en série. Le filtre est formé d'un cristal piézo-électrique délivrant une tension dépendante de la fréquence d'un signal d'entrée. Dans le dispositif décrit dans cette publication, seule la largeur de bande du cristal piézo-électrique est utilisée. Les caractéristiques dynamiques de ce cristal, et en particulier la pente de la courbe de réponse de la tension en fonction de la fréquence, n'interviennent pas. Ce dispositif ne peut être utilisé que pour démoduler des signaux modulés en amplitude et pas pour extraire des informations contenues dans une onde modulée angulairement, c'est-à-dire en fréquence ou en phase.

Le brevet américain US-A-4 006 424 décrit un circuit discriminateur de fréquence à large bande passante comportant un cristal piézo-électrique, une bobine d'induction et un condensateur. Ce circuit a une courbe de réponse délivrant une tension en fonction de la fréquence d'un signal d'entrée, cette courbe comportant une zone de discrimination opérant à une fréquence légèrement inférieure à la fréquence de coupure la plus basse du circuit. La discrimination est effectuée par la bobine d'induction et le condensateur, et le cristal piézo-électrique n'est utilisé que pour stabiliser la fréquence du circuit constitué de cette bobine et de ce condensateur. Cette réalisation présente différents inconvénients. Les bobines d'induction sont des composants électroniques coûteux. Leur utilisation augmente donc le prix de l'ensemble du dispositif. En outre, comme elles sont relativement grandes par rapport aux autres composants, leur utilisation est peu avantageuse dans des dispositifs dans lesquels la place disponible est limitée, ce qui est généralement le cas dans les boîtiers de montres. De plus, une bobine d'induction crée des couplages électromagnétiques indésirables lorsqu'elle est placée à proximité d'un moteur ou d'une antenne de réception. Une telle réalisation rend ce genre de discriminateurs difficilement utilisable, en particulier dans des montres.

La présente invention se propose de pallier ces inconvénients en réalisant un procédé et un dispositif de réception efficaces et simples pour capter et démoduler des signaux modulés angulairement, c'est-à-dire en fréquence ou en phase.

Ce but est atteint par un procédé tel que défini en préambule et caractérisé en ce que l'on filtre le signal radio d'entrée et l'on discrimine sa fréquence au moyen d'un discriminateur comportant au moins un résonateur à quartz dont la courbe de résonance d'origine définit une bande passante et une pente de flanc déterminées, la discrimination de ladite fréquence étant effectuée en utilisant au moins partiellement un flanc de la courbe de résonance dudit résonateur à quartz.

Selon un mode de réalisation préféré, on élargit la bande passante d'origine et l'on obtient la pente du flanc voulue dudit résonateur à quartz en y couplant une résistance en série.

On diminue avantageusement l'intensité des signaux situés hors de la bande passante du résonateur à quartz couplé à la résistance en générant deux signaux en opposition de phase à partir du signal capté et en transmettant l'un des signaux en opposition de phase audit résonateur à quartz et l'autre signal en opposition de phase à un réseau compensateur comportant un condensateur et une résistance en série.

Selon un mode de réalisation avantageux, on combine le signal sortant du résonateur à quartz et de la résistance avec le signal sortant du réseau compensateur, et on amplifie le signal combiné sortant du discriminateur au moyen d'un amplificateur à gain variable.

On commande de préférence le gain de l'amplificateur à gain variable au moyen d'un dispositif de commande automatique du gain de telle façon que le niveau moyen du signal sortant dudit amplificateur à gain variable soit sensiblement constant.

On réalise avantageusement une démodulation d'amplitude du signal sortant de l'amplificateur à gain variable au moyen d'un démodulateur d'amplitude comportant une diode conductrice en permanence.

Selon un premier mode de réalisation, on introduit dans une entrée positive d'un amplificateur différentiel d'un comparateur adaptatif, le signal sortant du démodulateur d'amplitude, et dans une entrée négative dudit amplificateur différentiel, une fraction de la valeur moyenne dudit signal sortant du démodulateur d'amplitude, cet amplificateur différentiel comportant une sortie agencée pour fournir un signal de sortie représentatif de l'information codée contenue dans le signal radio d'entrée.

Selon un deuxième mode de réalisation, on introduit le signal sortant du démodulateur d'amplitude dans un convertisseur analogique/numérique fournissant au moins un signal de sortie traité par un dispositif logique de type connu agencé pour extraire ladite information codée dudit signal d'entrée.

Ce but est également atteint par un dispositif tel que décrit en préambule et caractérisé en ce que ces moyens d'extraction comportent au moins un discriminateur comportant au moins un résonateur à quartz dont la courbe de résonance d'origine définit une bande passante et une pente de flanc déterminée, ce discriminateur étant agencé pour filtrer le signal radio d'entrée et pour discriminer sa fréquence en utilisant au moins partiellement un flanc de la courbe de résonance dudit résonateur à quartz.

Selon une forme de réalisation avantageuse, le dispositif comporte un préamplificateur agencé pour amplifier le signal capté par l'antenne de réception, et un étage qui génère des signaux en opposition de phase à partir du signal amplifié sortant du préamplificateur.

Le dispositif comporte avantageusement des moyens pour élargir la bande passante d'origine du résonateur à quartz et pour obtenir la pente de flanc voulue, ces moyens comprenant avantageusement une résistance.

Le discriminateur comporte avantageusement un réseau compensateur formé d'un condensateur et d'une résistance montés en série.

Selon une forme de réalisation préférée, I'étage qui génère des signaux en opposition de phase comporte une sortie connectée au résonateur à quartz et une sortie connectée au réseau compensateur.

Selon un mode de réalisation avantageux, lesdits moyens d'extraction comportent un amplificateur à gain variable agencé pour amplifier le signal combiné sortant dudit discriminateur, un circuit de commande automatique du gain agencé pour commander le gain de l'amplificateur à gain variable, et un circuit démodulateur d'amplitude comprenant une diode conductrice en permanence.

Selon une première forme de réalisation, lesdits moyens d'extraction comportent un comparateur adaptatif comprenant un amplificateur différentiel pourvu d'une entrée positive connectée à la sortie du démodulateur d'amplitude et d'une entrée négative connectée entre deux résistances dont l'une est reliée au démodulateur d'amplitude et dont l'autre est reliée à la masse électrique.

Selon une deuxième forme de réalisation, les moyens d'extraction comportent un convertisseur analogique/numérique connecté à la sortie du démodulateur d'amplitude.

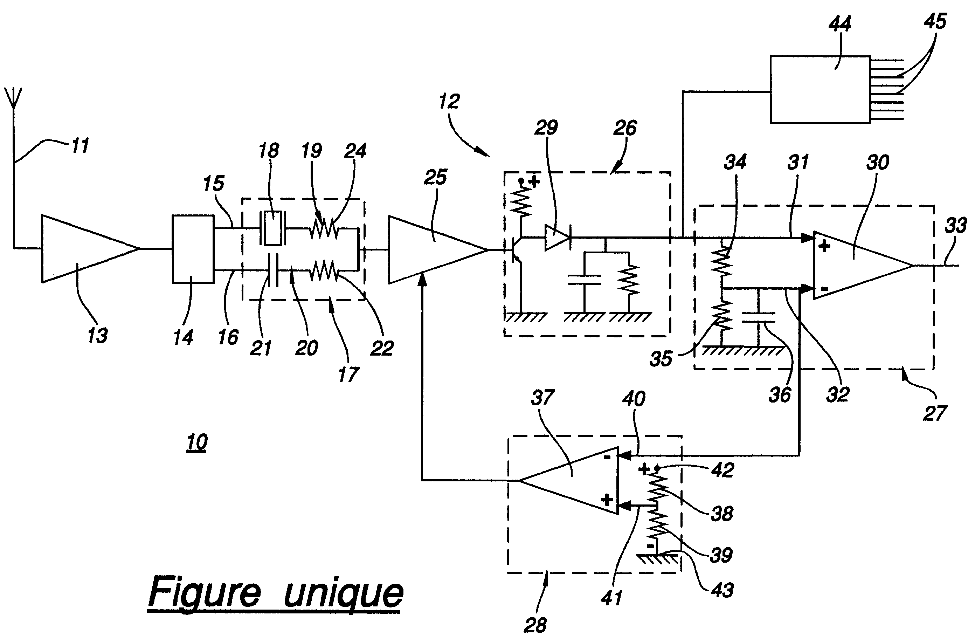

La présente invention et ses avantages apparaîtront mieux dans la description suivante d'un exemple de réalisation et en référence au dessin annexé, dans lequel la figure unique est une vue schématique du dispositif selon l'invention.

En référence à cette figure, le dispositif 10 de réception et d'extraction comporte une antenne de réception 11 agencée pour capter des signaux radio d'entrée émis par un émetteur (non représenté). Cet émetteur peut par exemple être du type de l'émetteur connu sous le nom de Télédiffusion de France abrégé TDF émettant une onde modulée en amplitude et en fréquence dont la porteuse a une fréquence moyenne de 162 kHz. Cette onde véhicule différentes informations réparties en trois catégories. La première catégorie, modulée en amplitude, contient des informations phoniques destinées à être reçues par un récepteur radiophonique. La deuxième catégorie, modulée en phase, contient des informations horaires destinées à la mise à l'heure de montres, pendules, etc. Finalement, la troisième catégorie, également modulée en phase, contient des données de type messagerie ou toutes autres informations numériques.

Le dispositif 10, qui est utilisé en coopération avec les ondes del'émetteur TDF modulées en phase, comporte également des moyens d'extraction 12 des informations contenues dans ces signaux radio. Ces moyens d'extraction comportent un préamplificateur 13 conventionnel destiné à amplifier les signaux captés par l'antenne 11. Les signaux amplifiés sont ensuite transmis à un étage 14 qui génère deux signaux en opposition de phase. Ces deux signaux sont respectivement transmis à deux entrées 15, 16 d'un discriminateur 17. La première entrée 15 du discriminateur 17 est connectée à une première branche comportant un résonateur à quartz 18 dont la courbe de résonance d'origine définit une bande passante et une pente de flanc déterminées et des moyens 19 permettant d'élargir la bande passante d'origine de ce résonateur à quartz et d'obtenir la pente de flanc voulue. La deuxième entrée 16 est connectée à une deuxième branche formant un réseau compensateur 20 constitué par exemple d'un condensateur 21 et d'une résistance 22 en série et dont la fonction est d'améliorer les caractéristiques de la première branche.

Le discriminateur 17 assume deux fonctions distinctes. La première fonction consiste à filtrer le signal sortant de l'étage 14. En utilisant un résonateur à quartz standard dont le coefficient de qualité d'origine est élevé, on obtient un filtre passe-bande ayant d'origine une faible largeur de bande. C'est pourquoi il est nécessaire d'y adjoindre les moyens 19 qui atténuent le coefficient de qualité et par voie de conséquence, élargissent la bande passante du filtre. Ces moyens 19 consistent en une résistance 24 placée en série avec le résonateur à quartz 18. La deuxième fonction de ce discriminateur 17 est de convertir les variations de fréquence du signal d'entrée en variations de tension électrique. La fréquence centrale du discriminateur est telle que la fréquence moyenne d'émission est située sur un flanc de la courbe de résonance du discriminateur. La résistance 24 contribue également à obtenir la pente de flanc désirée de manière à optimiser le gain de conversion fréquence-tension du discriminateur. Selon un mode de réalisation préféré mais non exclusif, la fréquence centrale d'émission est plus faible que la fréquence centrale du discriminateur et la fréquence centrale d'émission est proche du sommet de la courbe de résonance de ce discriminateur.

Lorsque l'on utilise un résonateur à quartz comme filtre passe-bande, les signaux de fréquences situées hors de sa bande passante d'origine sont très fortement atténués. Si l'on place une résistance en série avec le résonateur, la bande passante est élargie, mais les signaux situés hors de cette bande passante sont moins atténués. Ces signaux peuvent introduire des parasites dans le dispositif et nuire à son bon fonctionnement. En reliant le réseau compensateur 20 à la sortie 16 de l'étage 14 en opposition de phase par rapport à la sortie 15 connectée au résonateur à quartz 18, on atténue cet inconvénient.

Le dispositif 10 comporte également un amplificateur à gain variable 25, un démodulateur d'amplitude 26, un comparateur adaptatif 27 et un circuit 28 de commande automatique du gain.

L'amplificateur à gain variable 25 reçoit comme signal d'entrée, le signal combiné sortant des deux branches du discriminateur 17 et ressort un signal amplifié. Ce dernier traverse le démodulateur d'amplitude 26 qui fournit un signal démodulé. Le démodulateur d'amplitude comporte une diode 29 conductrice en permanence, de sorte que même pour un niveau très faible à l'entrée du démodulateur, on a un signal démodulé à la sortie.

Le signal démodulé est introduit dans le comparateur adaptatif 27. Plus précisément, ce comparateur adaptatif 27 comporte un amplificateur différentiel 30 ayant une entrée positive 31, une entrée négative 32 et une sortie 33. Le signal démodulé est transmis à l'entrée positive 31 de l'amplificateur différentiel. Les deux entrées 31 et 32 sont en outre reliées entre elles par l'intermédiaire d'une résistance 34. L'entrée négative 32 est connectée à une résistance 35 et à un condensateur 36 relié à la masse électrique. Cette connexion entraîne que l'entrée négative 32 de l'amplificateur différentiel 30 reçoit une tension égale à une fraction de la valeur moyenne de la tension du signal démodulé.

Le circuit 28 de commande automatique du gain comporte un amplificateur différentiel 37 et deux résistances 38, 39. L'entrée négative 32 de l'amplificateur différentiel 30 du comparateur adaptatif 27 est connectée à une entrée négative 40 de l'amplificateur différentiel 37 du circuit de commande 28. Cette entrée 40 reçoit donc également une tension égale à une fraction de la valeur moyenne de la tension du signal démodulé.

L'entrée positive 41 de l'amplificateur différentiel 37 est connectée entre les deux résistances 38, 39 dont l'une est reliée à une source d'alimentation positive 42 et dont l'autre est reliée à une source d'alimentation négative 43 ou à la masse électrique, donnant ainsi une tension de référence.

Le circuit 28 de commande du gain adapte le gain de l'amplificateur à gain variable 25 de façon que le rapport entre le niveau des deux entrées du circuit de commande 28 soit sensiblement constant et que l'amplificateur à gain variable 25 ne soit jamais saturé. De cette manière, on assure que la valeur moyenne du niveau de sortie du démodulateur d'amplitude 26 est sensiblement constante.

Si le dispositif selon l'invention est uniquement destiné à extraire des informations horaires des signaux captés, la sortie 33 de l'amplificateur différentiel 30 donne l'information horaire contenue dans le signal d'entrée.

Si le dispositif est également destiné à extraire d'autres informations que des informations horaires, la sortie du démodulateur 26 est connectée directement à une entrée d'un convertisseur analogique/numérique 44. Ce convertisseur comporte des sorties 45 délivrant des signaux numériques parallèles qui sont traités par un circuit logique de type connu ou par un microcontrôleur conventionnel (non représenté), adapté aux données extraites du signal radio d'entrée.

Le dispositif selon la présente invention permet de s'affranchir de l'utilisation d'une bobine d'induction dans la réalisation du discriminateur. Ceci permet son emploi dans des objets de petite dimension, comme par exemple des montres ou des montres-bracelets, ce qui n'est pratiquement pas possible en utilisant un dispositif comportant une bobine d'induction, du fait du volume relativement grand de ces bobines. Les bobines d'induction étant en outre relativement coûteuses, leur suppression permet de réduire le coût de fabrication. Finalement, de telles bobines d'induction créent un couplage électromagnétique indésirable qu'il faut supprimer en isolant la bobine, ce qui augmente le volume nécessaire, le coût de la fabrication et la complexité du montage.

Dans une autre variante de réalisation, Il est par exemple possible de connecter plusieurs résonateurs à quartz afin d'augmenter la sélectivité du dispositif et de se protéger plus fortement d'émetteurs indésirables.

## Revendications

1. Procédé de réception d'au moins un signal radio d'entrée comprenant au moins une information codée modulant angulairement ce signal, et d'extraction de cette information, ce procédé comportant les étapes consistant à capter ledit signal radio d'entrée, à l'amplifier, à le filtrer, à discriminer sa fréquence et à en extraire ladite information, caractérisé en ce que l'on filtre ce signal radio d'entrée et l'on discrimine sa fréquence au moyen d'un discriminateur (17) comportant au moins un résonateur à quartz (18) dont la courbe de résonance d'origine définit une bande passante et une pente de flanc déterminées, la discrimination de ladite fréquence étant effectuée en utilisant au moins partiellement un flanc de la courbe de résonance dudit résonateur à quartz.

2. Procédé selon la revendication 1, caractérisé en ce que l'on élargit la bande passante d'origine et l'on obtient la pente de flanc voulue dudit résonateur à quartz (18) en y couplant une résistance (24) en série.

3. Procédé selon la revendication 2, caractérisé en ce que l'on diminue l'intensité des signaux situés hors de la bande passante du résonateur à quartz (18) couplé à la résistance (24) en générant deux signaux en opposition de phase à partir du signal capté et en transmettant l'un des signaux en opposition de phase audit résonateur à quartz et l'autre signal en opposition de phase à un réseau compensateur (20) comportant un condensateur (21) et une résistance (22) en série.

4. Procédé selon la revendication 3, caractérisé en ce que l'on combine le signal sortant du résonateur à quartz (18) et de la résistance (24) avec le signal sortant du réseau compensateur (20), et en ce que l'on amplifie le signal combiné sortant du discriminateur (17) au moyen d'un amplificateur à gain variable (25).

5. Procédé selon la revendication 4, caractérisé en ce que l'on commande le gain de l'amplificateur à gain variable (25) au moyen d'un dispositif (28) de commande automatique du gain de telle façon que le niveau moyen du signal sortant dudit amplificateur à gain variable soit sensiblement constant.

6. Procédé selon la revendication 4, caractérisé en ce que l'on réalise une démodulation d'amplitude du signal sortant de l'amplificateur à gain variable (25) au moyen d'un démodulateur d'amplitude (26) comportant une diode (29) conductrice en permanence.

7. Procédé selon la revendication 6, caractérisé en ce que l'on introduit dans une entrée positive (31) d'un amplificateur différentiel (30) d'un comparateur adaptatif (27), le signal sortant du démodulateur d'amplitude (26), et dans une entrée négative (32) dudit amplificateur différentiel (30), une fraction de la valeur moyenne dudit signal sortant du démodulateur d'amplitude (26), cet amplificateur différentiel (30) comportant une sortie (33) agencée pour fournir un signal de sortie représentatif de l'information codée contenue dans le signal radio d'entrée.

8. Procédé selon la revendication 6, caractérisé en ce que l'on introduit le signal sortant du démodulateur d'amplitude (26) dans un convertisseur analogique/numérique (44) fournissant au moins un signal de sortie traité par un dispositif logique de type connu agencé pour extraire ladite information codée dudit signal d'entrée.

9. Dispositif de réception d'au moins un signal radio d'entrée comprenant au moins une information codée, modulant angulairement ce signal, et d'extraction de cette information, ce dispositif comportant une antenne de réception dudit signal radio d'entrée et des moyens d'extraction de ladite information, caractérisé en ce que ces moyens d'extraction (12) comportent au moins un discriminateur (17) comportant au moins un résonateur à quartz (18) dont la courbe de résonance d'origine définit une bande passante et une pente de flanc déterminées, ce discriminateur (17) étant agencé pour filtrer le signal radio d'entrée et pour discriminer sa fréquence en utilisant au moins partiellement un flanc de la courbe de résonance dudit résonateur à quartz.

10. Dispositif selon la revendication 9, caractérisé en ce qu'il comporte un préamplificateur (13) agencé pour amplifier le signal capté par l'antenne de réception, et un étage (14) qui génère des signaux en opposition de phase à partir du signal amplifié sortant du préamplificateur (13).

11. Dispositif selon la revendication 9, caractérisé en ce qu'il comporte des moyens (19) pour élargir la bande passante d'origine du résonateur à quartz (18) et pour obtenir la pente du flanc voulue.

12. Dispositif selon la revendication 11, caractérisé en ce que les moyens (19) comprennent une résistance (24).

13. Dispositif selon la revendication 9, caractérisé en ce que le discriminateur (17) comporte un réseau compensateur (20) formé d'un condensateur (21) et d'une résistance (22) montés en série.

14. Dispositif selon la revendication 13, caractérisé en ce que l'étage (14), qui génère des signaux en opposition de phase, comporte une sortie connectée au résonateur à quartz (18) et une sortie connectée au réseau compensateur (20).

15. Dispositif selon la revendication 9, caractérisé en ce que lesdits moyens d'extraction (12) comportent un amplificateur à gain variable (25) agencé pour amplifier le signal combiné sortant du discriminateur (17).

16. Dispositif selon la revendication 15, caractérisé en ce que lesdits moyens d'extraction (12) comportent un circuit (28) de commande automatique du gain, agencé pour commander le gain de l'amplificateur à gain variable (25).

17. Dispositif selon la revendication 9, caractérisé en ce que lesdits moyens d'extraction (12) comportent un circuit démodulateur d'amplitude (26) comprenant une diode (29) conductrice en permanence.

18. Dispositif selon la revendication 17, caractérisé en ce que lesdits moyens d'extraction (12) comportent un comparateur adaptatif (27) comprenant un amplificateur différentiel (30) pourvu d'une entrée positive (31) connectée à la sortie du démodulateur d'amplitude (26) et d'une entrée négative (32) connectée entre deux résistances (34, 35) dont l'une (34) est reliée au démodulateur d'amplitude (26) et dont l'autre (35) est reliée à la masse électrique.

19. Dispositif selon la revendication 17, caractérisé en ce que les moyens d'extraction (12) comportent un convertisseur analogique/numérique (44) connecté à la sortie du démodulateur d'amplitude (26).
